# EUROPEAN PATENT APPLICATION

(11) **EP 2 672 370 A2**
(43) Date of publication of application: **11.12.2013**
(21) Application number: 13170280.5
(22) Date of filing: 03.06.2013
(51) Int. Cl.: G06F 3/044

(54) **Touch-sensing electrode structure and touch-sensitive device**

(30) Priority: 04.06.2012 TW 101120002
(71) Applicant: Wintek Corporation, 42760 Taichung City (TW)
(72) Inventor: Chen, Kuo-Hsing, Hsin Pei City (TW); Chen, Yu-Ting, Pingzhen City, Taoyuan County (TW); Su, Chen-Hao, Feng Yuan City, Tai Chung County (TW); Su, Kuo-Chang, Shan Hua Town, Tai Nan County (TW)
(74) Representative: Urner, Peter

(57) **Abstract**

A touch-sensing electrode structure (20) has a plurality of electrode units (P). Each of the electrode units (P) includes at least one first electrode (22) and at least one second electrode (24). The second electrode (24) is formed in an area not overlapping the first electrode (22), and the first electrode has a first part (22a) and a second part (22b). The second electrode (24) is adjacent to the first part (22a) of the first electrode (22) and spaced apart the first part (22a) of the first electrode (22) by a first interval (d1), the second part (22b) of the first electrode (22) is adjacent to the second electrode (24) and spaced apart the second electrode (24) by a second interval (d2), and a width of the second interval (d2) is not equal to a width of the first interval (dl).

## Description

### BACKGROUND OF THE INVENTION

### a. Field of the Invention

The invention relates to a touch-sensing electrode structure and a touch-sensitive device.

### b. Description of the Related Art

Nowadays, a touch-sensing electrode structure of a capacitive touch-sensitive device is often fabricated using double-sided ITO or single-sided ITO fabrication processes. On forming conventional double-sided ITO patterns, coating, etching, and photolithography processes are performed on each of a top side and a bottom side of a glass substrate to form X-axis and Y-axis sensing electrodes on the two sides. However, except for being complicated, such fabrication processes may cause low production yields because of the step of flipping over the glass substrate to achieve double-sided patterning. In comparison, on forming conventional single-sided ITO patterns, since X-axis and Y-axis sensing electrodes are formed on the same side of a glass substrate, a bridge wiring structure needs to be formed in a touch screen area. In that case, unstable material characteristics of an organic insulation layer or other factors may cause short-circuit or open-circuit of the X-axis and Y-axis sensing electrodes. Therefore, a single-layer electrode structure is proposed to resolve above problems, where X-axis and Y-axis sensing electrodes are formed in the same layer to simplify fabrication process, increase production yields and reduce fabrication costs. However, the layout of single-layer ITO patterns needs to be optimized to have the full capability to perform capacitive touch-sensing controls, such as detecting variations in coupling capacitance at high sensitivity and achieving improved linearity of the electrical field.

### BRIEF SUMMARY OF THE INVENTION

The invention provides a touch-sensing electrode structure and a touch-sensitive device having high production yields, high sensitivity to touch-sensing controls and improved response linearity.

Other objects and advantages of the invention can be better understood from the technical characteristics disclosed by the invention. In order to achieve one of the above purposes, all the purposes, or other purposes, one embodiment of the invention provides a touch-sensing electrode structure having a plurality of electrode units. Each of the electrode units includes at least one first electrode and at least one second electrode. The second electrode is formed in an area not overlapping the first electrode, and the first electrode has a first part and a second part. The second electrode is adjacent to the first part of the first electrode and spaced apart the first part of the first electrode by a first interval, the second part of the first electrode is adjacent to the second electrode and spaced apart the second electrode by a second interval, and a width of the second interval is not equal to a width of the first interval.

In one embodiment, a width of the first interval and a width of the second interval are respectively determined by the intensity of an electric field around the first interval and the intensity of the electric field around the second interval.

In one embodiment, the second electrode substantially surrounds the first part of the first electrode, the second part of the first electrode substantially surrounds the second electrode, and an area of the first electrode is different to an area of the second electrode.

In one embodiment, the first electrode is a signal-sensing electrode, the second electrode is a signal-transmitting electrode, and an area of the second electrode is larger than or equal to an area of the first electrode.

In one embodiment, the first electrode is a signal-transmitting electrode, the second electrode is a signal-sensing electrode, and an area of the first electrode is larger than or equal to an area of the second electrode.

In one embodiment, an area of each of the electrode units is smaller than or equal to a touch area of a touch object in responsive to a touch action.

In one embodiment, a width of an interval between two adjacent electrode units is smaller than or equal to a width of each of the electrode units.

In one embodiment, each of the electrode units further comprises at least one third electrode, the third electrode is formed in an area not overlapping the first electrode and the second electrode, and the third electrode is grounded or connected to a sensing signal source.

In one embodiment, a width of each of first interval and the second interval is larger than 30µm.

In one embodiment, the second electrode has an opening, and the first part of the first electrode is linked with the second part of the first electrode via the opening.

In one embodiment, a width of the opening is larger than 30µm.

In one embodiment, at least one of the first electrode and the second electrode has an annular shape.

In one embodiment, each of the electrode units has at least one trace connected to a sensing signal source, and the trace is connected to one of the first electrode and the second electrode.

In one embodiment, a width of the trace is larger than 30µm, and a width of an interval between two adjacent traces is larger than 30µm.

According to another embodiment of the invention, a touch-sensitive device includes a substrate, a single-layer touch-sensing electrode structure, and a decoration layer. The single-layer touch-sensing electrode structure is disposed on the substrate and has a plurality of electrode units. Each of the electrode units includes at least one first electrode and at least one second electrode, the second electrode is formed in an area not overlapping the first electrode, and the first electrode has a first part and a second part, the second electrode is adjacent to the first part of the first electrode and spaced apart the first part of the first electrode by a first interval, the second part of the first electrode is adjacent to the second electrode and spaced apart the second electrode by a second interval, and a width of the second interval is not equal to a width of the first interval. An insulation layer may be interposed between the single-layer touch-sensing electrode structure and the substrate, and a passivation layer may be disposed on the substrate and covering the single-layer touch-sensing electrode structure and the decoration layer.

In one embodiment, the decoration layer may include at least one of photo resist, diamond-like carbon, ceramic, colored ink and resin, and the substrate may be a glass substrate or a plastic substrate.

According to another embodiment of the invention, a touch-sensitive device includes a substrate, an afore-mentioned single-layer touch-sensing electrode structure, and a cover lens. The single-layer touch-sensing electrode structure is disposed on the substrate, and the cover lens is combined with the single-layer touch-sensing electrode structure or the substrate.

In one embodiment, the cover lens has a decoration layer, and at least one curved surface is formed on at least one side of the cover lens.

According to the above embodiments, since the first electrode and the second electrode of a touch-sensing electrode structure are substantially surrounded with each other, the intensity of an electric field formed between the first electrode and the second electrode is increased to increase the amount of coupling capacitance and the sensitivity of touch-sensing controls for the touch-sensing electrode structure. Further, since the width of an interval between the first electrode and the second electrode may vary according to the position of the interval, the width of interval at a selected position can be adjusted to further increase the linearity of an electrical field. Besides, the electrode unit may additionally include a third electrode to improve visual effects, provide signal shading and avoid line breakage.

Other objectives, features and advantages of the invention will be further understood from the further technological features disclosed by the embodiments of the invention wherein there are shown and described preferred embodiments of this invention, simply by way of illustration of modes best suited to carry out the invention.

### BRIEF DESCRIPTION OF THE DRAWINGS

FIG. 1 shows a schematic diagram of a touch-sensitive device according to an embodiment of the invention.

FIG. 2 shows a schematic plan view of a touch-sensing electrode structure according to an embodiment of the invention. FIG. 3 shows a partial enlarged diagram of FIG. 2.

FIGS. 4A and 4B show schematic diagrams illustrating the effect of adjusting a width of an interval between electrodes.

FIG. 5 shows a schematic plan view of a touch-sensing electrode structure according to another embodiment of the invention.

FIG. 6 shows a schematic plan view of a touch-sensing electrode structure according to another embodiment of the invention.

FIG. 7 shows a schematic plan view of a touch-sensing electrode structure according to another embodiment of the invention.

FIG. 8 shows a schematic diagram of a touch-sensitive device according to another embodiment of the invention.

FIG. 9 shows a schematic diagram of a touch-sensitive device according to another embodiment of the invention.

### DETAILED DESCRIPTION OF THE INVENTION

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

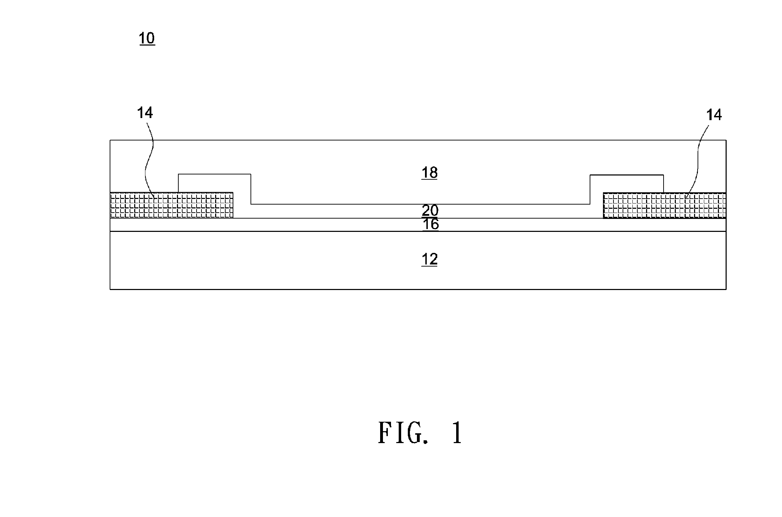

FIG. 1 shows a schematic diagram of a touch-sensitive device according to an embodiment of the invention. Referring to FIG. 1, in a touch-sensitive device 10, a touch-sensing electrode structure 20 is disposed on a substrate 12, and a decoration layer 14 is disposed on at least one side of a periphery of the substrate 12. The substrate 12 may be a cover lens, and the decoration layer 14 may include at least one of photo resist, diamond-like carbon, ceramic, colored ink and resin. The substrate 12 may be a glass substrate or a plastic substrate. An insulation layer 16 may be interposed between the touch-sensing electrode structure 20 and the substrate 12, and a passivation layer 18 may be disposed on the substrate 12 and covers the touch-sensing electrode structure 20 and the decoration layer 14.

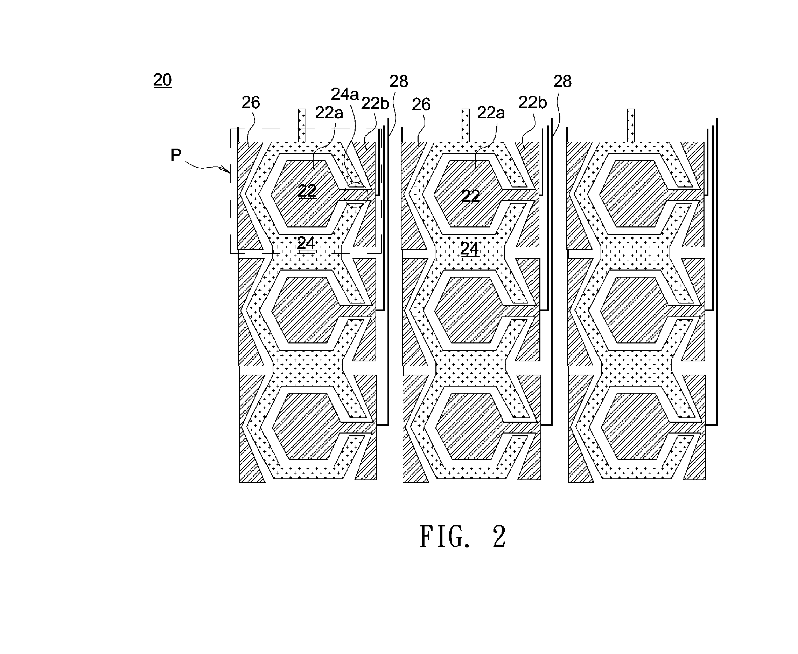

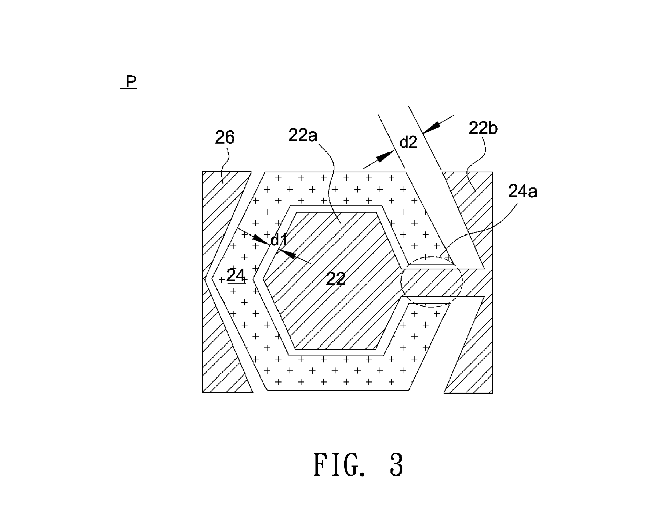

According to an embodiment of the invention, the touch-sensing electrode structure 20 is in the form of a single-layer electrode structure. FIG. 2 shows a schematic plan view of a touch-sensing electrode structure according to an embodiment of the invention. FIG. 3 shows a partial enlarged diagram of FIG. 2. Please refer to both FIG. 2 and FIG. 3, the touch-sensing electrode structure 20 may include multiple regularly arranged electrode units P. Each electrode unit P includes at least one first electrode 22 and at least one second electrode 24, the second electrode 24 is formed in an area not overlapping the first electrode 22 and substantially divides the first electrode 22 to allow the first electrode 22 to have a first part 22a and a second part 22b. That is, at least a part of the second electrode 24 is disposed in a gap formed between the second part 22b and the first part 22a of the first electrode 22. In this embodiment, the second electrode 24 substantially surrounds the first part 22a of the first electrode 22 and is spaced apart from the first part 22a of first electrode 22 by a first interval d1. The second part 22b of the first electrode 22 is adjacent to the second electrode 24 and spaced apart from the second electrode 24 by a second interval d2. In one embodiment, a width of the second interval d2 may be set as not equal to a width the first interval d1.

In this embodiment, the first part 22a of the first electrode 22 may be in the shape of a polygon such as a hexagon, and the second electrode 24 may have an annular shape (such as a hexagonal ring shown in FIG. 3). The second part 22b of the first electrode 22 may include multiple electrode blocks that are connected with each other. Further, an opening 24a may be formed in the second electrode 24, and the first part 22a of the first electrode 22 may be linked with the second part 22b of the first electrode 22 via the opening 24a. In this embodiment, all second electrodes 24 of electrode units P arranged in an identical direction (such as a vertical direction shown in FIG. 2) may be connected with each other to form a signal-transmitting electrode, and each first electrode 22 may serve as a signal-sensing electrode.

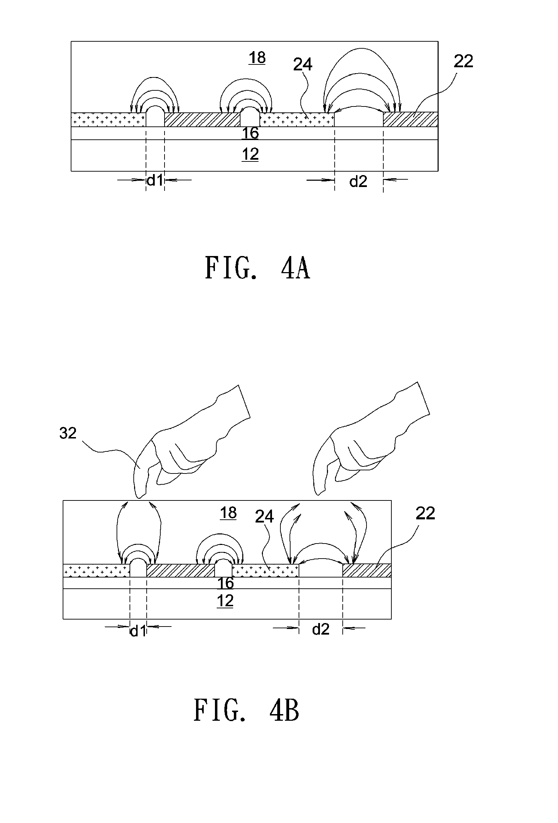

According to the above embodiment, the second electrode 24 surrounds the first part 22a of the first electrode 22, and the second part 22b of the first electrode 22 is adjacent to the second electrode 24. Therefore, the first electrode 22 and the second electrode 24 are substantially surrounded with each other, and thus the intensity of an electric field formed between the first electrode 22 and the second electrode 24 is increased to increase the amount of coupling capacitance and the sensitivity of touch-sensing controls for the touch-sensing electrode structure 20. Further, since the width of the second interval d2 is set as not equal to the width of the first interval d1, a width difference between the first interval d1 and the second interval d2 can be adjusted to further increase the sensitivity of touch-sensing controls and the linearity of an induced electrical field. For example, as shown in FIG. 4A and FIG. 4B, in case the second interval d2 is larger than the first interval d1, a binding force of the electric field induced by electrodes 22 and 24 beside the first interval d1 is larger than a binding force of the electric field induced by electrodes 22 and 24 beside the second interval d2. Therefore, when a finger 32 approaches electrodes 22 and 24, the extent of an electric field affected by finger capacitance is varied according to the width of an interval. Specifically, a variation in coupling capacitance as the finger 32 approaching the second interval d2 is larger than a variation in coupling capacitance as the finger 32 approaching the first interval d1. Since the intensity of an electric field around the first interval d1 is different to the intensity of an electric field around the second interval d2, the width of intervals at different positions can be adjusted to equalize the capacitance variation at two different positions and hence further enhance the linearity of an electrical field induced in touch-sensing controls. Note a width of an interval recited in the above embodiments may be, but not limited to, referred to as an average width of an interval.

Please refer to FIG. 2 again, in this embodiment, the electrode unit P may further include at least one third electrode 26. The third electrode 26 may be formed in an area not overlapping the first electrode 22 and the second electrode 24 to enhance visual effects. Besides, the third electrode 26 may be grounded to provide signal shielding effects between adjacent electrode units P. Alternatively, the third electrode 26 may be connected to a sensing signal source to serve as an auxiliary sensing signal line. When a touch object such as a finger 32 draw a line across two adjacent electrode units P, the third electrode 26 existing between two adjacent electrode units P may be also used to detect the finger 32 to avoid the problem of line breakage.

Typically, an unduly large electrode unit P may lower the touch-sensing resolution of a touch panel, but an unduly small electrode unit P may cause a considerable number of channels. Therefore, in one embodiment, an area of each electrode unit P may be set as smaller than or equal to a touch area of a touch object (such as the finger 32) in responsive to a touch action. Besides, in one embodiment, a width of an interval between two adjacent electrode units P may be set as smaller than or equal to a width of an electrode unit P to avoid insufficient coupling capacitance due to an unduly large interval and to provide linear response on drawing a line

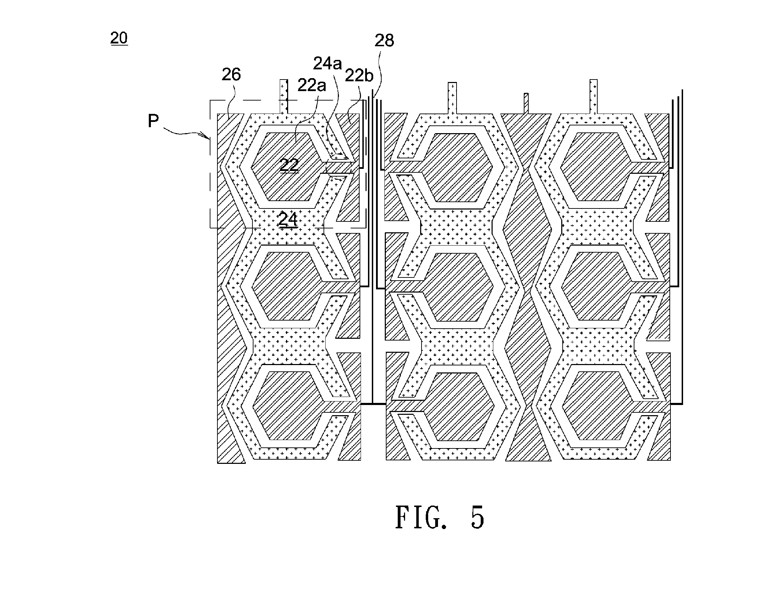

Further, each first electrode 22 is connected to a sensing signal source (such as an IC) via at least one trace 28. The distribution of multiple traces 28 is not restricted. For example, the traces 28 may be disposed on the same side (such as the right side shown in FIG. 2) of the electrode units P. Alternatively, as shown in FIG. 5, the traces 28 may be disposed on different sides of the electrode units P, such as alternating between the right side and left side of the electrode units P arranged in a horizontal row.

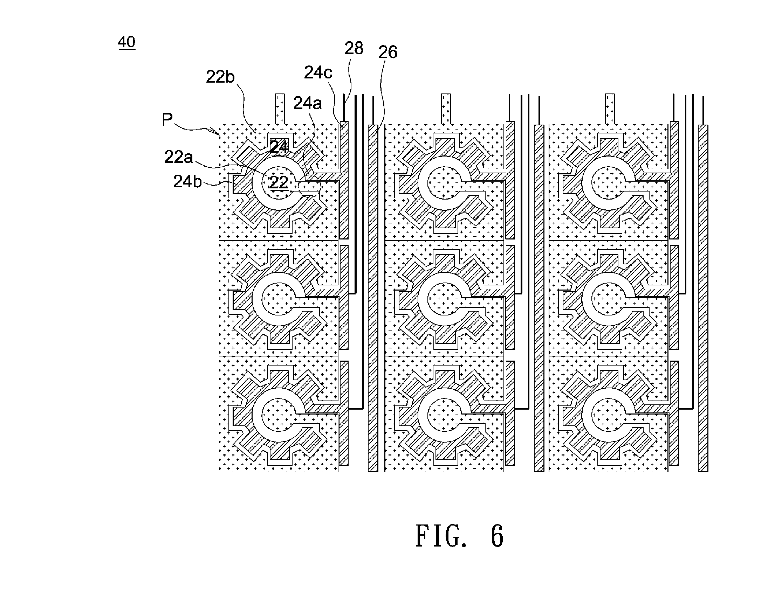

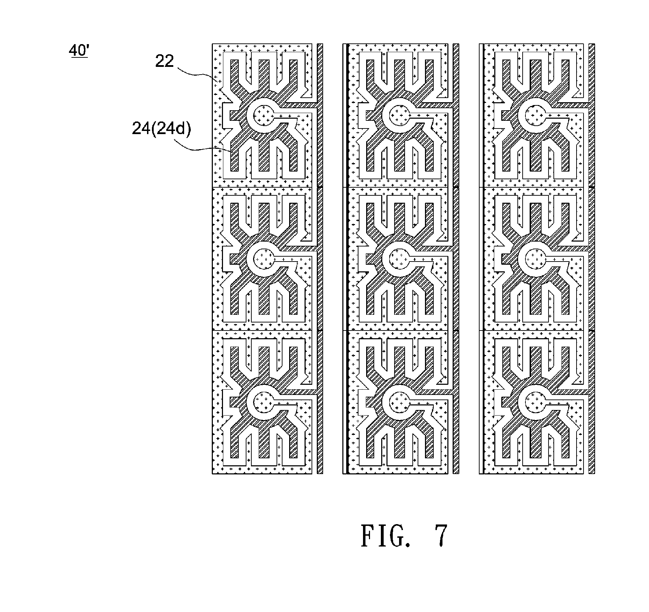

FIG. 6 shows a schematic plan view of a touch-sensing electrode structure according to another embodiment of the invention. As shown in FIG. 6, the touch-sensing electrode structure 40 may include multiple regularly arranged electrode units P. Each electrode unit P includes at least one first electrode 22 and at least one second electrode 24, the second electrode 24 is formed in an area not overlapping the first electrode 22, and the first electrode 22 has a first part 22a and a second part 22b. The second electrode 24 substantially surrounds the first part 22a of the first electrode 22, and the second part 22b of the first electrode 22 substantially surrounds the second electrode 24. In this embodiment, the first part 22a of the first electrode 22 is in the shape of a circle, and the second part 22b is in the shape of a polygon. The second electrode 24 has an annular shape and has multiple protrusions 24b, and the second electrode 24 has a stripe portion 24c that is beside the second part 22b of the first electrode 22 and extends in a vertical direction. The stripe portions 24c and the protrusions 24b may also serve as touch-sensing areas to increase the amount of coupling capacitance. Further, an opening 24a may be formed in the second electrode 24, and the first part 22a of the first electrode 22 may be linked with the second part 22b of the first electrode 22 via the opening 24a. In this embodiment, all first electrodes 22 of the electrode units P arranged in an identical direction (such as a vertical direction shown in FIG. 6) are connected with each other to form a signal-transmitting electrode, and each second electrode 24 may serve as a signal-sensing electrode. Further, the electrode unit P may additionally include a third electrode 26 to improve visual effects, provide signal shading and avoid line breakage. Besides, each second electrode 24 is connected to a sensing signal source (such as an IC) via at least one trace 28. The distribution of multiple traces 28 is also not restricted. Note the shape of the first part 22a of the first electrode 22, the second part 22b of the first electrode 22, the second electrode 24, and the third electrode 26 is not restricted to the shape exemplified in the above embodiments. For example, in an alternate embodiment shown in FIG. 7, each second electrode 24 of a touch-sensing electrode structure 40' may have multiple branches 24d having longer lengths compared with the lengths of the protrusions 24b shown in FIG. 6.

In one embodiment, an opening 24a of the second electrode 24 has a width of larger than 30µm. In case the first electrode 22 serves as a signal-sensing electrode and the second electrode 24 serves as a signal-transmitting electrode, the second electrode 24 is larger than or equal to the first electrode 22 in area. In comparison, in case the first electrode 22 serves as a signal-transmitting electrode and the second electrode 24 serves as a signal-sensing electrode, the first electrode 22 is larger than or equal to the second electrode 24 in area. In one embodiment, a width of a trace of each electrode unit P may be larger than 30µm, and a width of an interval between two adjacent traces may be larger than 30µm.

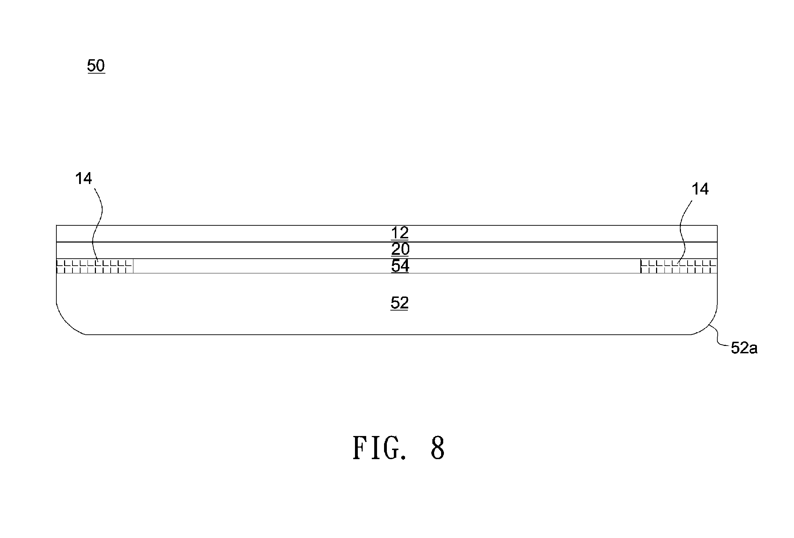

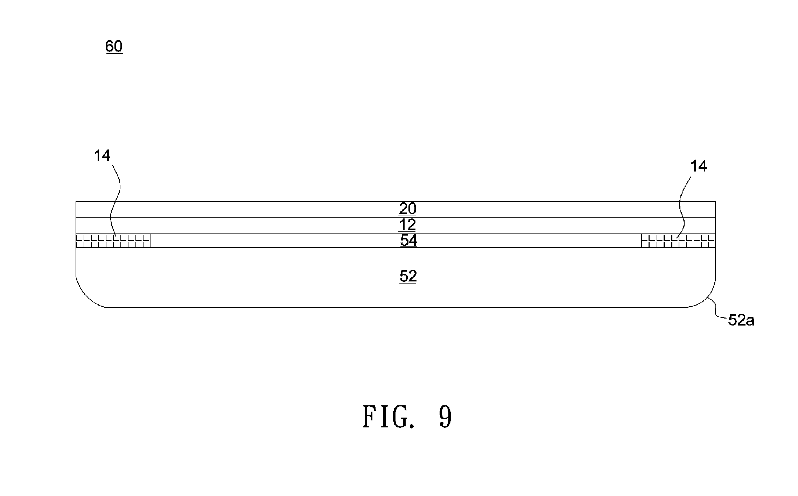

FIG. 8 shows a schematic diagram of a touch-sensitive device according to another embodiment of the invention. As shown in FIG. 8, the touch-sensing electrode structure 20 may be disposed on a substrate 12 first and then combined with a cover lens 52 having a decoration layer 14 to form a touch-sensitive device 50. The cover lens 52 may be combined with a touch-sensing electrode structure 20 by an optical adhesive 54. Alternatively, as shown in FIG. 9, the cover lens 52 of a touch-sensitive device 60 has a decoration layer 14 and is attached to a substrate 12 having a touch-sensing electrode structure 20. At least one curved surface 52a may be formed on at least one side of the cover lens 52 by machining process such as edging or chamfering.

According to the above embodiments, since the first electrode and the second electrode of a touch-sensing electrode structure are substantially surrounded with each other, the intensity of an electric field formed between the first electrode and the second electrode is increased to increase the amount of coupling capacitance and the sensitivity of touch-sensing controls for the touch-sensing electrode structure. Further, since the width of an interval between the first electrode and the second electrode may vary according to the position of the interval, the width of interval at a selected position can be adjusted to further increase the linearity of an electrical field. Besides, the electrode unit may additionally include a third electrode to improve visual effects, provide signal shading and avoid line breakage.

The foregoing description of the preferred embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to particularly preferred exemplary embodiments of the invention does not imply a limitation on the invention, and no such limitation is to be inferred. The invention is limited only by the spirit and scope of the appended claims. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret or limit the scope or meaning of the claims. Any advantages and benefits described may not apply to all embodiments of the invention. It should be appreciated that variations may be made in the embodiments described by persons skilled in the art without departing from the scope of the invention as defined by the following claims. Moreover, no element and component in the present disclosure is intended to be dedicated to the public regardless of whether the element or component is explicitly recited in the following claims. Each of the terms "first" and "second" is only a nomenclature used to modify its corresponding element. These terms are not used to set up the upper limit or lower limit of the number of elements.

## Claims

1. A touch-sensing electrode structure having a plurality of electrode units, wherein each of the electrode units comprises:
at least one first electrode; and
at least one second electrode formed in an area not overlapping the first electrode, wherein the first electrode has a first part and a second part, the second electrode is adjacent to the first part of the first electrode and spaced apart the first part of the first electrode by a first interval, the second part of the first electrode is adjacent to the second electrode and spaced apart the second electrode by a second interval, and a width of the second interval is not equal to a width of the first interval.

2. The touch-sensing electrode structure as claimed in claim 1, wherein a width of the first interval and a width of the second interval are respectively determined by the intensity of an electric field around the first interval and the intensity of the electric field around the second interval.

3. The touch-sensing electrode structure as claimed in claim 1, wherein the second electrode substantially surrounds the first part of the first electrode, and the second part of the first electrode substantially surrounds the second electrode.

4. The touch-sensing electrode structure as claimed in claim 1, wherein an area of the first electrode is different to an area of the second electrode.

5. The touch-sensing electrode structure as claimed in claim 1, wherein the first electrode is a signal-sensing electrode, the second electrode is a signal-transmitting electrode, and an area of the second electrode is larger than or equal to an area of the first electrode.

6. The touch-sensing electrode structure as claimed in claim 1, wherein the first electrode is a signal-transmitting electrode, the second electrode is a signal-sensing electrode, and an area of the first electrode is larger than or equal to an area of the second electrode.

7. The touch-sensing electrode structure as claimed in claim 1, wherein an area of each of the electrode units is smaller than or equal to a touch area of a touch object in responsive to a touch action.

8. The touch-sensing electrode structure as claimed in claim 1, wherein a width of an interval between two adjacent electrode units is smaller than or equal to a width of each of the electrode units.

9. The touch-sensing electrode structure as claimed in claim 1, wherein each of the electrode units further comprises at least one third electrode, the third electrode is formed in an area not overlapping the first electrode and the second electrode, and the third electrode is grounded or connected to a sensing signal source.

10. The touch-sensing electrode structure as claimed in claim 1, wherein the second electrode has an opening, and the first part of the first electrode is linked with the second part of the first electrode via the opening.

11. The touch-sensing electrode structure as claimed in claim 1, wherein at least one of the first electrode and the second electrode has an annular shape, each of the electrode units has at least one trace connected to a sensing signal source, and the trace is connected to one of the first electrode and the second electrode.

12. A touch-sensitive device, comprising:
a substrate;
a single-layer touch-sensing electrode structure disposed on the substrate and having a plurality of electrode units, each of the electrode units comprises at least one first electrode and at least one second electrode, wherein the second electrode is formed in an area not overlapping the first electrode, the first electrode has a first part and a second part, the second electrode is adjacent to the first part of the first electrode and spaced apart the first part of the first electrode by a first interval, the second part of the first electrode is adjacent to the second electrode and spaced apart the second electrode by a second interval, and a width of the second interval is not equal to a width of the first interval; and
a decoration layer disposed on at least one side of a periphery of the substrate.

13. The touch-sensitive device as claimed in claim 12, wherein the decoration layer comprises at least one of photo resist, diamond-like carbon, ceramic, colored ink and resin, and the substrate is a glass substrate or a plastic substrate.

14. The touch-sensitive device as claimed in claim 12, further comprising:
an insulation layer interposed between the single-layer touch-sensing electrode structure and the substrate; and
a passivation layer disposed on the substrate and covering the single-layer touch-sensing electrode structure and the decoration layer.

15. A touch-sensitive device, comprising:
a substrate;
a single-layer touch-sensing electrode structure disposed on the substrate and having a plurality of electrode units, each of the electrode units comprises at least one first electrode and at least one second electrode, wherein the second electrode is formed in an area not overlapping the first electrode, the first electrode has a first part and a second part, the second electrode is adjacent to the first part of the first electrode and spaced apart the first part of the first electrode by a first interval, the second part of the first electrode is adjacent to the second electrode and spaced apart the second electrode by a second interval, and a width of the second interval is not equal to a width of the first interval; and
a cover lens combined with the single-layer touch-sensing electrode structure or the substrate.

16. The touch-sensitive device as claimed in claim 15, wherein the cover lens has a decoration layer.

17. The touch-sensitive device as claimed in claim 15, wherein at least one curved surface is formed on at least one side of the cover lens.
